Europäisches Patentamt

European Patent Office

Office européen des brevets

(11) Veröffentlichungsnummer: **0 432 399 A2**

## (12) EUROPÄISCHE PATENTANMELDUNG

(21) Anmeldenummer: **90119370.6**

(22) Anmeldetag: **10.10.90**

(51) Int. Cl.5: **H03G 3/20**

(30) Priorität: **17.11.89 DE 3938210**

(43) Veröffentlichungstag der Anmeldung:
**19.06.91 Patentblatt 91/25**

(84) Benannte Vertragsstaaten:
**AT DE FR NL**

(71) Anmelder: **ROBERT BOSCH GmbH**
**Postfach 10 60 50**
**W-7000 Stuttgart 10(DE)**

(72) Erfinder: **Müller, Wolfgang**
**Weimarer Strasse 19**
**W-1000 Berlin 12(DE)**

(74) Vertreter: **Schmidt, Hans-Ekhardt, Dipl.-Ing.**
**Robert Bosch GmbH Geschäftsbereich**
**Mobile Kommunikation Patent- und**
**Lizenzabteilung Forckenbeckstrasse 9-13**
**W-1000 Berlin 33(DE)**

(54) **Breitbandiges Übertragungssystem.**

(57)
2.1 In Groß-Gemeinschaftsantennen-Anlagen werden Regelverstärker zur Kompensation von Kabeldämpfungs- und Verstärkungsänderungen verwendet werden. Diese Regelverstärker haben eine Zwei-Pilotregelung mit einem unteren und einem oberen Piloten.

2.2 Erfindungsgemäß wird nach einer ersten Übertragungsstrecke (23) ein erster Regelverstärker (11, 12, 20) eingeschaltet, der eine erste Dämpfungsänderung ausregelt, und nach einer zweiten Übertragungsstrecke (24) wird ein zweiter Regelverstärker (13, 14, 21) eingeschaltet, der eine zweite Dämpfungsänderung ausregelt. Vorteilhaft werden die Regelverstärker (11, 12, 20; 13, 14, 21) zyklisch in die Übertragungsstrecke (23, 24) eingesetzt.

2.3 Geregelte breitbandige VHF-UHF-Übertragungsstrecke.

Fig. 3

## BREITBANDIGES ÜBERTRAGUNGSSYSTEM

Die Erfindung betrifft ein breitbandiges Übertragungssystem nach dem Oberbegriff des Anspruchs 1.

Aus "Funkschau, 1975, Heft 8, S. 111 bis 116" ist eine Pegelschaltung in Groß-Gemeinschaftsantennen-Anlagen be kannt, bei der Regelverstärker zur Kompensation von Kabeldämpfungs- und Verstärkungsänderungen verwendet werden. Üblich ist dabei eine Zwei-Pilotregelung mit einem unteren und einem oberen Piloten. Der untere Pilot regelt ein Parallelregelglied, der obere ein Schräglageregelglied. Eine Regelung bei langen kaskadierten Übertragungsstrecken ist notwendig, da die kaskadierten Komponenten wie Kabel und Verstärker ein temperaturabhängiges Amplitudenübertragungsverhalten zeigen.

Zu dem temperaturabhängigen Amplitudenübertragungsverhalten der Kabel kommen in der Praxis Änderungen der Verstärkung der aktiven Elemente hinzu. Kabeldämpfungsänderungen sind Schräglageänderungen, Verstärkungsänderungen hingegen in der Regel Paralleländerungen. Bei langen Streckenabschnitten überwiegt die Schräglageänderung, bei kurzen die Paralleländerung.

Wegen dem für die Regelglieder notwendigen Dynamikvorhalt ist das dynamische Verhalten - Verhältnis zwischen Ausgangsleistung und Rauschen bei Regelverstärkern immer schlechter als bei ungeregelten Verstärkern. Ein Zwei-Pilot-Regelverstärker mit einem Parallel- und einem Schräglageregelglied ist also dynamisch schlechter als ein Ein-Pilot-Regelverstärker.

Bei der Realisierung eines Regelverstärkers werden in der Praxis handelsübliche aktive Bauteile verwendet. Diese müssen durch evtl. Kombinationen an die Streckenlängen angepaßt werden. Durch Verwendung handelsüblicher Hybridschaltungen mit konstanter Verstärkung kann z. B. die Überschußverstärkung für einen Zwei-Pilot-Regelverstärker ohne einen zusätzlichen Verstärker nicht ausreichen, was für die Dynamik negative Folgen hat. Andererseits müßte bei ungeregelten Verstärkern eine evtl. Überschußverstärkung weggedämpft werden, so daß kein dynamischer Vorteil gegenüber dem geregelten Verstärker erzielt wird.

Der Erfindung liegt die Aufgabe zugrunde, ein breitbandiges Übertragungssystem anzugeben, die Kabeldämpfungsänderungen und Verstärkungsänderungen mit einfachen Mitteln ausgleicht.

Diese Aufgabe wird bei einem breitbandigen Übertragungssystem nach dem Oberbegriff des Anspruchs 1 durch die im Kennzeichen angegebenen Merkmale gelöst.

Weiterbildungen und vorteilhafte Ausgestaltungen der Erfindung ergeben sich aus den Ansprüchen, der weiteren Beschreibung und der Zeichnung.

Erfindungsgemäß wird ein breitbandiges Übertragungssystem vorgeschlagen, daß eine Zwei-Pilotregelung mit einem unteren und einem oberen Piloten aufweist und den möglichen Dynamikbereich erhält. Die für eine Zwei-Pilotregelung erforderlichen Regelglieder für die Parallel- und Schräglageregelung werden in getrennten Verstärkern eingesetzt. Somit wird in der erfindungsgemäßen breitbandigen Übertragungssystem ein Regelverstärker mit einem Schräglageregelglied und einem oberen Piloten sowie ein Regelverstärker mit einem Parallelregelglied und einem unteren Piloten verwendet. Diese Verstärker werden zyklisch in die Übertragungsstrecke eingesetzt, vorzugsweise evtl. auch zusammen mit ungeregelten Verstärkern.

Da durch die erfindungsgemäße Lösung der Dynamikbereich optimal ausgenutzt wird, sind längere Übertragungsstrecken möglich.

Gegebenenfalls kann der erste in die Übertragungsstrecke eingesetzte Verstärker ein Regelverstärker mit einem Parallelregelglied sein.

Nachfolgend wird die Erfindung anhand der Zeichnung näher erläutert.

In der Zeichnung zeigen:

Fig. 1 eine Parallelregelung

Fig. 2 eine Schräglageregelung

Fig. 3 eine geregelte breitbandige Übertragungsstrecke

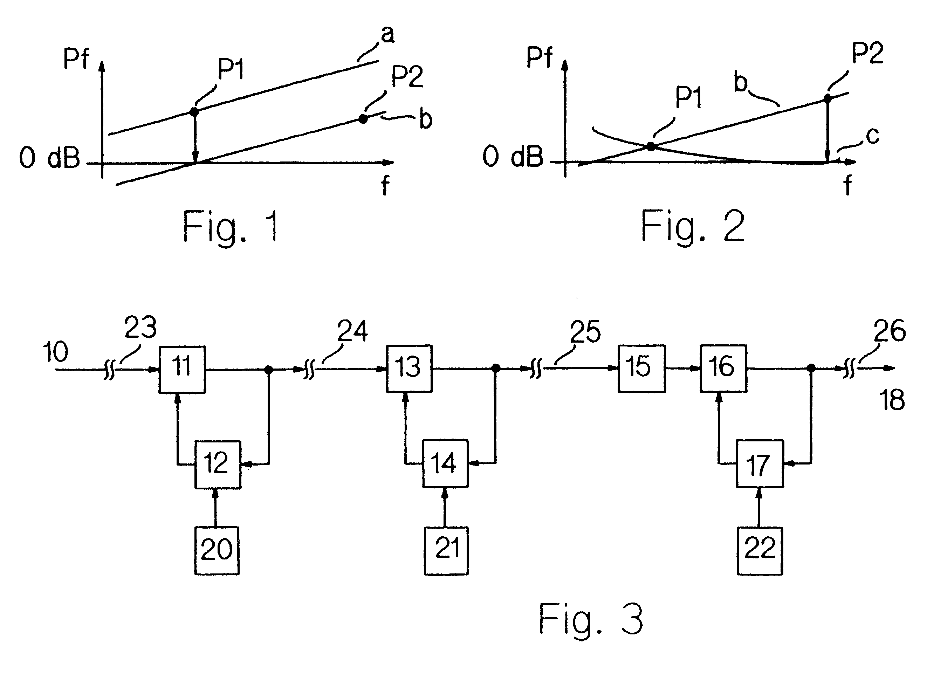

Fig. 1 zeigt eine Parallelregelung. Am Eingang eines Parallel-Regelverstärkers weist das Signal einen Pegelfehler Pf gemäß Kurve a auf, der über den Frequenzbereich f ansteigend ist. Der Parallel-Regelverstärker regelt auf einen unteren Piloten P1 das breitbandige Signal auf 0 dB Pegelfehler entsprechend Kurve b. Für die Signalkomponenten oberhalb des unteren Piloten P1 verbleibt somit ein Pegelfehler Pf. Mit dem Parallel-Regelverstärker werden frequenzunabhängige Dämpfungen ausgeregelt.

Fig. 2 zeigt eine Schräglageregelung. Am Eingang eines Schräglage-Regelverstärkers weist das Signal einen Pegelfehler Pf gemäß Kurve b auf. Der Schraglage-Regelverstärker regelt auf einen oberen Piloten P2 das breitbandige Signal auf 0 dB Pegelfehler Pf entsprechend Kurve c. Für die Signalkomponenten unterhalb des oberen Piloten P2 verbleibt ein Pegelfehler Pf. Mit dem Schräglage-Regelverstärker werden frequenzabhängige Dämpfungen ausgeregelt.

Fig. 3 zeigt eine geregelte breitbandige Übertragungsstrecke. Ein breitbandiges Signal, z. B. ein VHF-UHF-Signal, wird an einem Eingang 10 einer Übertragungsstrecke 23 eingespiest und durch diese entsprechen Fig. 1, Kurve a gedämpft. In einem entsprechenden Abschnitt der Übertragungsstrecke 23 ist ein Parallel-Regelverstärker 11 eingesetzt. Zur Ermittlung der Regelgröße wird der untere Pilot P1 in einer Ist/Sollwertvergleichsschaltung 12 aus dem breitbandigen Signal ausgefiltert. Seine Dämpfung wird mit einem von einer Referenzquelle 20 gelieferten Sollwert verglichen. Die ermittelte Regelgröße wird einem Stellglied des Parallel-Regelverstärkers 11 zugeführt. Am Ausgang des Parallel-Regelverstärkers 11 wird das Signal entsprechend Fig. 1, Kurve b in eine anschließende Übertragungsstrecke 24 eingespeist.

Nach einer Dämpfung entsprechen Fig. 2, Kurve b durch die Übertragungsstrecke 24 wird ein Schräglage-Regelverstärker 13 in die Übertragungsstrecke 24 eingesetzt. Zur Ermittlung der Regelgröße wird der obere Pilot P2 in einer Ist/Sollwertvergleichsschaltung 14 aus dem breitbandigen Signal ausgefiltert und seine Dämpfung mit einem von einer Referenzquelle 21 gelieferten Sollwert verglichen. Die ermittelte Regelgröße wird einem Stellglied des SchräglageRegelverstärkers 13 zugeführt. Am Ausgang des SchräglageRegelverstärkers 13 wird das Signal entsprechend Fig. 2, Kurve c in eine anschließende Übertragungsstrecke 25 eingespeist.

Je nach Länge der Gesamtübertragungsstrecke können weitere der oben beschriebenen Regelverstärker verwendet werden, wobei je nach Übertragungsstreckeneigenschaften oder eingefügten Abzweigungen unterschiedliche Kombinationen von Parallel- oder Schräglageregelverstärkern eingesetzt werden können. Es wird zwar aus Kostengründen in der Regel angestrebt, ungeregelte Verstärker zu verwenden. Haben geregelte und ungeregelte Verstärker jedoch gleiches dynamisches Verhalten, ist es für das Verhalten der Gesamtstrecke am günstigsten, nur Regelverstärker zu verwenden.

In dem Ausführungsbeispiel ist am Ende der Übertragungsstrecke 25 vor einem Regelverstärker 16 mit Ist/Sollwertvergleichsschaltung 17 und Referenzquelle 22 ein ungeregelter Verstärker 15 vorgeschaltet. Dieser Regelverstärker 16 kann ein Parallel- oder Schräglageregelverstärker sein. Über eine Übertragungsstrecke 26 wird das breitbandige Signal auf einen Ausgang 18 gegeben.

Die Erfindung beschränkt sich in ihrer Ausführung nicht auf das vorstehend angegebene bevorzugte Ausführungsbeispiel. Vielmehr ist eine Anzahl von Varianten denkbar, welche von der dargestellten Lösung auch bei grundsätzlich anders gearteten Ausführungen Gebrauch macht.

## Ansprüche

1. Breitbandiges Übertracungssystem mit Regelverstärker zur Kompensation von Kabeldämpfungs- und Verstärkungsänderungen, **dadurch gekennzeichnet,** daß nach einer ersten Übertracungsstrecke (23) ein erster Regelverstärker (11, 12, 20) eingeschaltet ist, der eine erste Dämpfungsänderung ausregelt, und daß nach einer zweiten Übertragungsstrecke (24) ein zweiter Regelverstärker (13, 14, 21) eingeschaltet ist, der eine zweite andersgeartete Dämpfungsänderung ausregelt.

2. Übertragungssystem nach Anspruch 1, **dadurch gekennzeichnet,** daß als erster Regelverstärker (11, 12, 20) ein Regelverstärker mit einem Schräglageregelglied und einem oberen Piloten (P2) und als zweiter Regelverstärker (13, 14, 21) ein Regelverstärker mit einem Parallelregelglied und einem unteren Piloten (P1) verwendet wird.

3. Übertragungssystem nach Anspruch 1, **dadurch gekennzeichnet,** daß als erster Regelverstärker (11, 12, 20) ein Regelverstärker mit einem Parallelregelglied und einem unteren Piloten (P1) und als zweiter Regelverstärker (13, 14, 21) ein Regelverstärker mit einem Schräglageregelglied und einem oberen Piloten (P2) verwendet wird.

4. Übertragungssystem nach einem oder mehreren der Ansprüche 1 bis 3, **dadurch gekennzeichnet,** daß die Regelverstärker (11, 12, 20; 13, 14, 21) zyklisch in die Übertragungsstrecke (23, 24) eingesetzt werden.

5. Übertragungssystem nach einem oder mehreren der Ansprüche 1 bis 4, **dadurch gekennzeichnet,** daß die Regelverstärker (11, 12, 20; 13, 14, 21) einen ungeregelten Verstärker (15) enthalten.

Fig. 1

Fig. 2

Fig. 3